# EUROPEAN PATENT APPLICATION

(11) **EP 2 353 722 A1**
(43) Date of publication of application: **10.08.2011**
(21) Application number: 10153012.9
(22) Date of filing: 09.02.2010
(51) Int. Cl.: B01L 7/00, H01L 23/34

(54) **Heat dissipation of power electronics for thermocyclers**

(71) Applicant: F. Hoffmann-La Roche AG, 4070 Basel (CH); Roche Diagnostics GmbH, 68305 Mannheim (DE)
(72) Inventor: Federer, Paul, 6110 Wolhusen (CH); Egli, Roman, 8008 Zürich (CH); Hermann, Pius, 6280 Urswil (CH)
(74) Representative: Herren, Barbara

(57) **Abstract**

A thermocycler block is disclosed wherein a printed circuit board comprising power electronics (8) is mounted on the heat sink (5) of the heat block (1) of the thermocycler, thereby causing dissipation of heat produced by the power electronics through the heat dissipation system of the heat block.

## Description

The present invention relates to heat dissipation of power electronics on a printed circuit board of a thermocycler block.

Devices for tempering samples or reaction mixtures in a controlled way are used in almost all fields of chemistry or biochemistry. Since labor time as well as reagents are expensive, development is tending to increase the throughput of production and analysis, while at the same time, to minimize the necessary reaction volumes.

In general, tempering devices have a thermal block that is in thermal contact with the sample under investigation. The thermal block is tempered to a desired temperature affecting the temperature of the sample, too. The simplest thermal block is a common boilerplate. In order to realize an efficient tempering, the device should have means to heat and cool the samples. For this purpose, the thermal block can be connected with two separate means or with a single means able to perform both heating and cooling. Such a single tempering means is e.g. a flow-through means, whereas a pipe system within or close to the thermal block is streamed with an externally tempered fluid, e.g. water or oil, transporting heat to or from the thermal block. In case of two separate means, in general, a resistive heating in combination with a dissipative cooling is utilized. A good summary about thermal management in the field of medical and laboratory equipment is written by Robert Smythe (Medical Device & Diagnostic Industry Magazine, Jan. 1998, p. 151-157.

A common dissipative cooling device is a heat sink in combination with a fan. Generally, heat sinks are made from aluminum because of the metal's relatively high thermal conductivity and low cost. They are extruded, stamped, bonded, cast, or machined to achieve a shape that will maximize surface area, facilitating the absorption of heat by the surrounding cooler air. Most have a fin or pin design. When used with fans (forced convection), heat sinks can dissipate large amounts of heat while keeping the targeted components at 10 - 15 °C above ambient temperature. Heat sinks are inexpensive and offer installation flexibility but cannot cool components at or below ambient temperature. Also, heat sinks do not permit temperature control.

More sophisticated setups utilize thermoelectric devices (TEC) as heat pumps for heating and active cooling of a thermal block. Thermoelectric devices are solid-state heat pumps made from semiconductor materials comprising a series of p-type and n-type semiconductor pairs or junctions sandwiched between ceramic plates. Heat is absorbed by electrons at the cold junction as they pass from a low energy level in a p-type element to a higher energy level in an n-type element. At the hot junction, energy is expelled to e.g. a heat sink as the electrons move from the high-energy n-type element to a low-energy p-type element. A dc power supply provides the energy to move the electrons through the system. A typical TEC will contain up to 127 junctions and can pump as much as 120 W of heat. The amount of heat pumped is proportional to the amount of current flowing through the TEC and therefore, tight temperature control is possible. By reversing the current, TECs can function as heaters or coolers, which can be useful in controlling an object in changing ambient environments or in cycling at different temperatures. Sizes range from 2 to 62 mm, and multiple TECs can be used for greater cooling. Because of the relatively large amount of heat being pumped over a small area, TECs in general require a heat sink to dissipate the heat into the ambient environment. A well known type of TECs is the Peltier elements.

The dissipation of heat is essential for efficient cooling. If the heat can not be dissipated at its origin, said heat can be transferred to another place using heat pipes. A heat pipe is a sealed vacuum vessel with an inner wick structure that transfers heat by the evaporation and condensation of an internal working fluid. Ammonia, water, acetone, or methanol are typically used, although special fluids are used for cryogenic and high-temperature applications. As heat is absorbed at one side of the heat pipe, the working fluid is vaporized, creating a pressure gradient within the heat pipe. The vapor is forced to flow to the cooler end of the pipe, where it condenses, giving up its latent heat to the wick structure and than to the ambient environment via e.g. a heat sink. The condensed working fluid returns to the evaporator via gravity or capillary action within the inner wick structure. Because heat pipes exploit the latent heat effect of the working fluid, they can be designed to keep a component near ambient conditions. Though they are most effective when the condensed fluid is working with gravity, heat pipes can work in any orientation. Heat pipes are typically small and highly reliable, but they can not cool objects below ambient temperature.

A thermal block can be tempered with two heat pipes, whereas one heat pipe transports heat from a heat source to said thermal block and whereas the other heat pipe transports heat away from said thermal block. A thermal block with two heat pipes is disclosed in WO 01/51209. A plurality of heat pipes are used in US 4,950,608 to realize a temperature regulating container. A heat pipe with a controllable thermal conductance is disclosed in US 4,387,762.

A thermocycling device for performing a plurality of individual samples in a parallel manner is described in WO 2006/105919.

Thermocycling devices comprise power and control electronics for controlling the heating and cooling process. Power electronics produce heat which has to be dissipated. Commonly, heat dissipation of power and control electronics on a printed circuit board by placing the printed circuit board in the airstream of the ventilator of the cooling unit.

The present invention relates to an improved thermocycler block, thermocycler and method for dissipating heat produced by power electronics in the thermocycler.

### Description

The present invention relates to a thermocycler block. Said thermocycler block comprises heat block for holding receptacles containing samples to be incubated; a heat sink for dissipating heat from said heat block when the temperature of the heat block has to be reduced; heat pump elements connected to said heat block and to said heat sink; and a printed circuit board comprising power electronics for providing power to the heat pump elements.

The printed circuit board is in direct contact with the heat sink for dissipating heat generated by the power electronics.

A heat block 1 is a solid state device disposed to have a good thermal conductance. There is a plurality of materials known to someone skilled in the art that have a good thermal conductance and without being bound to theory, most materials having a good electrical conductance are good thermal conductors, too. Therefore, materials like copper, aluminum, silver or graphite are suitable for the thermal block. On the other hand, also plastics and ceramics may have sufficient thermal conductance to be used as material for the thermal block. The heat block comprises a plurality of receptacles which can hold a plurality of reaction vessels.

A heat pump 2 is an active device that is able to transport heat. In general heat pumps are so-called thermoelectric devices (TEC) made from semiconductor materials that need electricity to work. A dc power supply provides the energy for heating and cooling, whereas reversing the current does reverse the direction of heat being pumped. A well known type of TECs are the Peltier elements.

A heat sink 5 is a device to dissipate heat. In general, a heat sink is made out of a thermally conductive material analogous to the thermal block outlined before. Therefore, heat sinks are mostly made out of metal, preferably out of aluminum or copper. Another suitable material for heat sinks is graphite. Alternatively, heat sinks may be formed out of plastics and ceramics, if only a good thermal conductance is realized. In order to realize a maximum dissipation of heat, heat sinks are disposed to provide a large surface-to-volume ratio. This is realized by an assembly of fins arranged on a base plate. A large surface-to-volume ratio reduces the heat transfer resistance between the heat sink and the surrounding air.

One advantage of the thermocycler block according to the present invention is that the power electronics on the printed circuit board are located in proximity of the heat pump, and thus, no cables or wiring is required. This prevents energy losses caused by transport of power through wiring. There is also less likelihood for malfunctions, the thermocycler is more robust during operation. Furthermore, this is also more user friendly since it is not necessary to remove contacts between printed circuit board and the functions requiring power if there is a malfunction. Instead, the entire thermocycler block can be removed from the thermocycler for testing and repair.

In a preferred embodiment of the thermocycler block as hereinbefore described, the printed circuit board additionally comprises control electronics for controlling the power electronics. A very compact printed circuit board can thereby be achieved.

Preferably, the heat block is fixed to said circuit board. The thermocycler block preferably also comprises a heat distribution and equalization device located between said circuit board and said heat sink.

In one preferred embodiment, said heat distribution and equalization device is a thermal base 4. More preferred is a vapor chamber device for transporting and distributing heat. Throughout the present invention a thermal base is a special heat pipe, whereas said thermal base has regions of substantially planar shape. The term heat pipe is an established name for a sealed vacuum vessel with an inner wick structure that transfers heat by the evaporation and condensation of an internal working fluid. As heat is absorbed at one side of the heat pipe, the working fluid is vaporized, creating a pressure gradient within said heat pipe. The vapor is forced to flow to the cooler end of the heat pipe, where it condenses, giving up its latent heat to the ambient environment. The condensed working fluid returns to the evaporator via gravity or capillary action within the inner wick structure. A thermal base in general is a passive device, but it can be designed as an active device, too, if said thermal base is equipped with control means. Said control means modify the thermal conductivity of the thermal base by adjusting either the flow rate within the enclosure or the volume of the enclosure affecting the vacuum within the vessel.

Besides the heat pipes, the evaporated solid state enclosure with a liquid-vapor equilibrium in form of a pipe, these solid state enclosure are also known in a plate-like form produced by the company Thermacore (Lancester, USA), called Therma-Base™. These Therma-Base™ have a substantially planar shape and are used e.g. in computers to distribute heat generated at integrated circuits (US 6,256,199). An apparatus for temperature regulation of elements in thermal contact with a fluid contained in liquid-vapor equilibrium inside an enclosure is disclosed in US 5,161,609. US 5,819,842 describes a temperature control unit comprising a spreader plate for the independent control of multiple samples which are in close proximity.

In a preferred embodiment, the heat pumps are Peltier elements. Preferably, the thermocycler block additionally comprises Peltier elements between said heat block and said heat distribution and equalization device.

In a preferred embodiment, the thermocycler block additionally comprises a ventilator, wherein said ventilator is located below the heat sink. Further preferred is a thermocycler block comprising Peltier elements coupled to said printed circuit board and said heat sink.

The present invention also relates to a thermocycler comprising a thermocycler block as hereinbefore described. The thermocycler further comprises a photometer comprising a light source and a CCD for detecting optical signals and a housing. The light source preferably comprises at least one LED.

The present invention further relates to a method of dissipating heat generated by power electronics in a thermal cycler, said method comprising contacting a printed circuit board comprising said power electronics with a heat sink, wherein said heat sink additionally dissipates heat from a heat block within said thermocycler. Preferably, the method additionally comprises dissipating heat dissipated by said heat sink with a ventilator. More preferably, in the method hereinbefore described, said printed circuit board additionally comprises control electronics for controlling the power electronics.

The phrase multiple samples comprises any number of samples, whereas said multiple samples can be arrange in several ways. A common way to arrange multiple samples is the use of microtiter plates. Alternatively, multiple reaction vessels may be arranged in a holding means. Within the scope of the present invention, the multiple samples are fluid samples. Each of said multiple samples comprises a solvent and one or more solved targets to be analyzed.

### Figures:

Fig. 1 shows one specific embodiment of a thermocycler block according to the present invention.
Fig. 2 shows a schematic view of a thermocycler with a thermocycler block according to the present invention.
Fig. 3 shown a schematic view of the assembly of a thermocycler block with Peltier elements, thermabase, heat sink and ventilator.

### Example

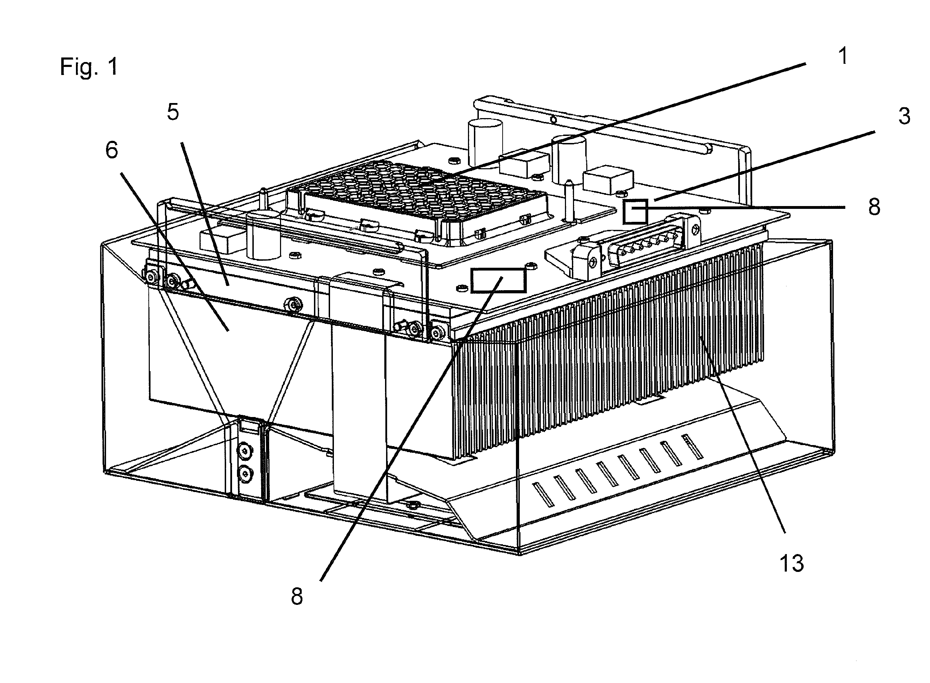

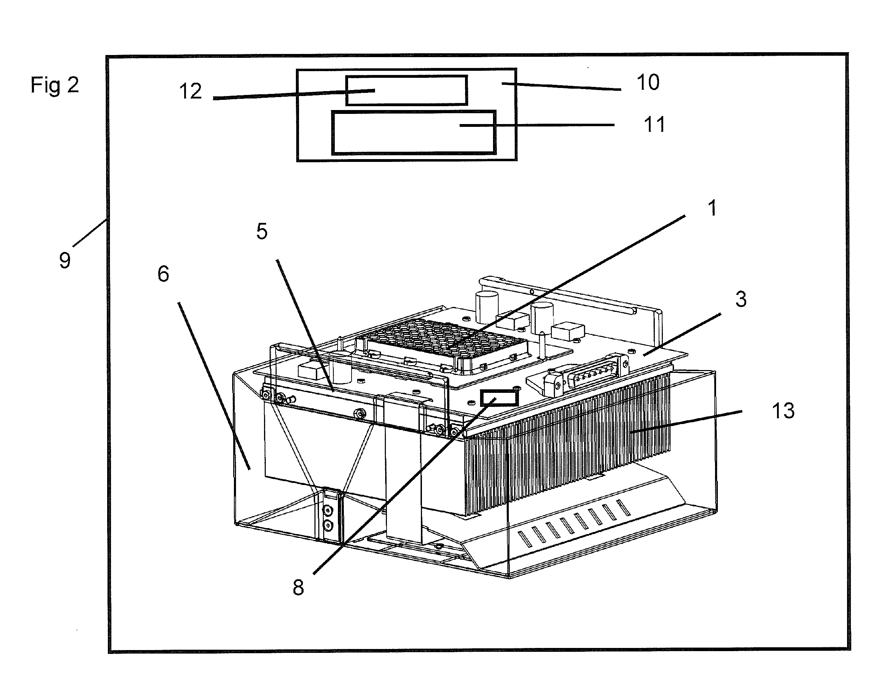

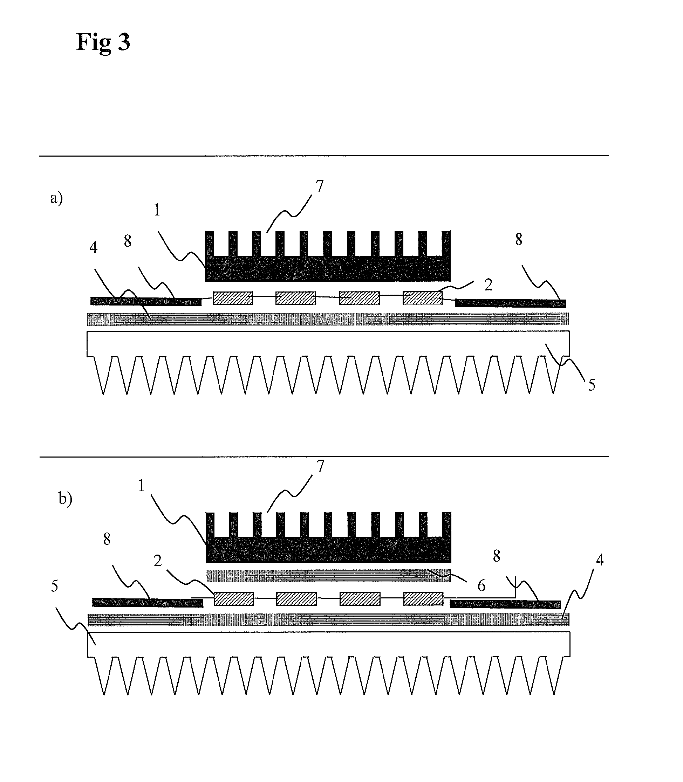

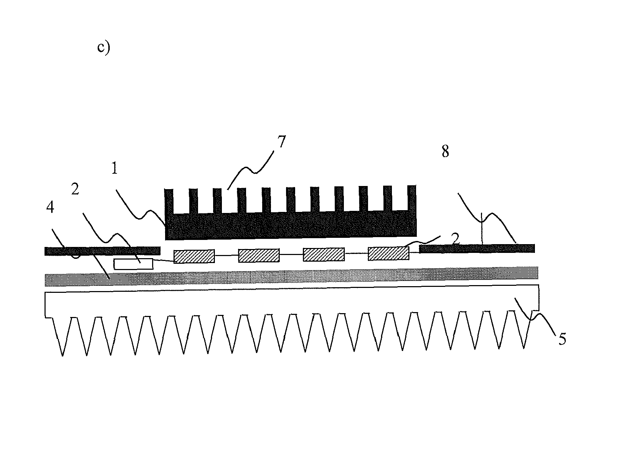

A thermocycler block (6) as shown in Fig. 1 comprises a heat block (1) comprising receptacles (7), a heat sink (5), a thermal base (4), a printed circuit board (3) with power electronics (8) and a ventilator (13). The heat block can be inserted and removed into a thermal cycler (9) comprising a photometer (10) with a light source (11) and a CCD (12) (Fig. 2). The thermoblock (6) can further comprise heat pumps (2), preferably Peltier elements (2), as is shown in Fig. 3. Fig. 3 a and b show embodiments in which the Peltier elements (2) are located between heat block (1) and the thermabase (4). Fig. 3 c) shows an embodiment where at least one Peltier element (2) is also located between the printed circuit board (3) with the power electronics (8) and the thermabase (4).

## Claims

1. A thermocycler block comprising
- a heat block for holding receptacles containing samples to be incubated;
- a heat sink for dissipating heat from said heat block when the temperature of the heat block has to be reduced;
- heat pump elements connected to said heat block and to said heat sink;
- a printed circuit board comprising power electronics for providing power to said heat pump elements,
wherein said printed circuit board is in direct contact with said heat sink for dissipating heat generated by the power electronics.

2. The thermocycler of claim 1, wherein said printed circuit board additionally comprises control electronics for controlling the power electronics.

3. The thermocycler of claims 1 or 2, wherein said heat block is fixed to said circuit board.

4. The thermocycler according to any one of claims 1 to 3, additionally comprising a heat distribution and equalization device located between said circuit board and said heat sink.

5. The thermocycler according to any one of claims 1 to 4, additionally comprising Peltiers elements between said heat block and said heat distribution and equalization device.

6. The thermocycler according to any one of claims 1 to 5, additionally comprising a ventilator, wherein said ventilator is located below the heat sink.

7. The thermocycler according to any one of claims 1 to 6, wherein said heat pump elements comprise Peltier elements.

8. The thermocycler according to any one of claims 1 to 7, comprising Peltier elements coupled to said printed circuit board and said heat sink.

9. A thermocycler comprising
- a thermocycler block according to any one of claims 1 to 8;
- a photometer comprising a light source and a CCD for detecting optical signals;
- a housing.

10. The thermocycler of claim 9, wherein said light source comprises at least one LED.

11. A method of dissipating heat generated by power electronics in a thermal cycler, said method comprising contacting a printed circuit board comprising said power electronics with a heat sink, wherein said heat sink additionally dissipates heat from a heat block within said thermocycler.

12. The method of claim 11, additionally comprising dissipating heat dissipated by said heat sink with a ventilator.

13. The method according to claims 11 or 12, wherein said printed circuit board additionally comprises control electronics for controlling the power electronics.
